# EUROPÄISCHE PATENTANMELDUNG

(11) **EP 0 757 387 A1**
(43) Veröffentlichungstag der Anmeldung: **05.02.1997**
(21) Anmeldenummer: 95120440.3
(22) Anmeldetag: 22.12.1995
(51) Int. Cl.: H01L 23/495, H01L 21/56

(54) **Leadframe für die Lead-on-Chip-Montage und seine Verwendung zur Herstellung eines Gehäuses für einen an ihm befestigten Chip**

(71) Anmelder: SIEMENS AKTIENGESELLSCHAFT, 80333 München (DE)
(72) Erfinder: Pohl, Jens, D-93170 Bernhardswald (DE)

(57) **Zusammenfassung**

Der Leadframe 6 weist erste innere Leads (1) auf, die mit ihren nach innen weisenden Enden einen innerhalb des Leadframes (6) angeordneten, von Leads freien Bereich (3) nach zwei sich gegenüberliegenden Seiten begrenzen. Außerdem weist er wenigstens ein Begrenzungselement (2) auf, welches beispielsweise ein zweiter innerer Lead sein kann und den freien Bereich (3) nach einer dritten Seite begrenzt. Die Begrenzungselemente (2) dienen zur Beeinflussung der Fließgeschwindigkeit einer von der dritten Seite einer Kavität (5) eines Umpreßwerkzeuges zugeführten Preßmasse bei der Gehäuseherstellung für einen auf dem Leadframe (6) montierten Chip (7).

## Beschreibung

Die Erfindung betrifft einen Leadframe für die Lead-on-Chip(LOC-)Montage und ein Verfahren zur Herstellung eines Gehäuses für einen damit verbundenen Chip. Derartige Leadframes weisen innere Leads auf, die zur Kontaktierung mit Anschlußpads eines Chips dienen. Die inneren Leads werden bei der Chipmontage auf dem Chip - meist mittels einer Klebefolie - befestigt. Außerdem weisen Leadframes äußere Leads auf, die mit den inneren Leads elektrisch verbunden sind und zur äußeren Kontaktierung des Chips (beispielsweise mit einer Leiterplatte) über den Leadframe dienen. Die inneren und äußeren Leads werden von einem Rahmen gehalten, der im Laufe des Herstellungsprozesses entfernt wird, so daß dann nur noch einander zugeordnete der inneren und äußeren Leads elektrisch miteinander verbunden sind.

Es sind Leadframes bekannt, bei denen die inneren Leads von zwei sich gegenüberliegenden Seiten aufeinander zu weisen, wobei ihre nach innen weisenden Enden einen von Leads freien Bereich von zwei Seiten begrenzen. Dieser freie Bereich ist oft symmetrisch in der Mitte des Leadframes längs einer seiner Achsen angeordnet. Ist der Leadframe auf einem Chip montiert, befinden sich in diesem freien Bereich die Anschlußpads des Chips, die mit den Enden der inneren Leads - für gewöhnlich über Bonddrähte - kontaktierbar sind.

Für die Herstellung eines Kunststoffgehäuses für den mit dem Leadframe verbundenen Chip kommen sogenannte Preßmassen (dies sind wärmehärtende Duroplaste) zum Einsatz. Chip und Leadframe werden in einen Hohlraum (eine sogenannte "Kavität") in einem entsprechenden Umpreßwerkzeug ("Moldwerkzeug") eingebracht, in den anschließend die zähflüssige Preßmasse eingepreßt wird. Auf diese Weise werden die über und unter dem Chip befindlichen Teile der Kavität mit Preßmasse gefüllt. So entstehen die Ober- und die Unterseite des Chipgehäuses. Die Öffnung zum Einspritzen der Preßmasse in die Kavität, das sogenannte "Gate", befindet sich dabei üblicherweise an einer dritten Seite des Chips, nach welcher der freie Bereich nicht begrenzt ist.

Beim Umpressen der Chips mit Duroplasten tritt nun das Problem auf, das sich die Preßmasse an der Ober- und Unterseite des Chips unterschiedlich schnell und u.U. auch unregelmäßig ausbreitet. Hierdurch können sich Fließmarken, offene Löcher ("Pinholes") oder eingeschlossene Luftblasen ("Voids", Lunker) im herzustellenden Gehäuse bilden. Dieses Problem ist umso größer, je dünner das herzustellende Gehäuse ist. Zu unterschiedlichen Ausbreitungsgeschwindigkeiten der Preßmasse kommt es, da die Chipunterseite eine homogene, glatte Fläche darstellt, während an der Chipoberseite der Leadframe befestigt ist, dessen innere Leads andere Strömungsverhältnisse für die Preßmasse bedingen. Die inneren Leads sind gewöhnlich mittels einer Klebefolie auf der Oberseite des Chips befestigt, und auch diese wirkt sich auf die Ausbreitung der Preßmasse aus. Das beschrieben Problem taucht vor allem bei großflächigen Chips bzw. Leadframes auf. Im Extremfall kann der Chip durch den unterschiedlichen Preßmassenfluß an seiner Ober- und Unterseite aus seiner Position gepreßt werden, so daß er zerbricht oder nicht ausreichend mit Preßmasse umgeben wird, so daß er nach der Fertigstellung des Gehäuses auf dessen Unterseite hervorragt. In der Regel strömt die Preßmasse an der Oberseite des Chips schneller als an seiner Unterseite.

Es ist bekannt, eine sogenannte "verlorene Kavität" vorzusehen, die im Umpreßwerkzeug in Flußrichtung der Preßmasse hinter dem Chip (und damit hinter der für die Gehäuseherstellung verwendeten "normalen" Kavität) angeordnet ist. Allerdings löst die verlorene Kavität nur das Problem der Voids und Lunker, wohingegen die ungleichmäßige Ausbreitung der Preßmasse und die damit verbundenen Nachteile des Niederdrückens des Chips bestehen bleiben. Außerdem hat diese Lösung den Nachteil, daß spezielle Umpreßwerkzeuge notwendig sind, die eine solche verlorene Kavität aufweisen. Ferner ist eine verlorene Kavität für kleinflächigere Chips nicht notwendig und u.U. sogar ungünstig. Es müssen dann Umpreßwerkzeuge mit und ohne verlorene Kavität bereitgehalten werden. Außerdem sind zusätzliche Prozeßschritte notwendig, die zur Beseitigung der durch die verlorene Kavität aufgenommenen Preßmasse dienen, welche nach ihrem Erstarren zunächst mit dem herzustellenden Gehäuse verbunden ist.

Eine Lösung des Problems der ungleichmäßigen Ausbreitung der Preßmasse und der damit verbundenen starken Belastung des Chips sieht eine Anpassung der Lage des Chips in der Kavität des Umpreßwerkzeugs vor. Durch eine höhere oder tiefere Anordnung ist nämlich eine Beeinflussung der Fließgeschwindigkeit der Preßmasse an der Chipober- und -unterseite möglich. Jedoch hat dieses Vorgehen direkten Einfluß auf die Dicke des Ober- und Unterteiles des Gehäuses, so daß sich u.U. nicht mehr Gehäuse mit den gewünschten Dimensionen realisieren lassen. Es ist dann auch nicht möglich, Chips, die unterschiedlich große Flächen aufweisen, in identischen Umpreßwerkzeugen zu verarbeiten. Gerade dies ist aber z.B. bei TSOP-(Thin Small Outline Package-)Gehäusen für DRAMs der Generationen 16 MBit und 64 MBit erwünscht. Ursache für diesen Nachteil ist die bereits beschriebene Abhängigkeit der Fließgeschwindigkeit der Preßmasse von der Chipgröße. Es ergeben sich folgende zwei Nachteile: Zum einen sind für zwei Chips mit unterschiedlich großen Flächen unterschiedliche Umpreßwerkzeuge notwendig bzw. es muß eine Anpassung der Lage der Chips in der Kavität erfolgen können. Zum anderen sind dann zwar Gehäuse der gleichen Familie (d.h. mit gleicher Grundfläche, aber evt. voneinander abweichender Anzahl äußerer Leads; Beispiel: TSOP50 für 64 M-DRAM, TSOP50/44 für 16 M-DRAM), jedoch nur mit voneinander abweichenden Dicken der Gehäuseober- und -unterteile erzeugbar.

Der Leadframe gemäß Anspruch 1 und das Verfahren nach Anspruch 9 lösen die Aufgabe, die Herstellung eines Gehäuses für einen in LOC-Technik montierten Chip zu ermöglichen, bei der in günstiger Weise Lufteinschlüsse, Fließmarken und offene Löcher vermieden werden, ohne daß die geschilderten Nachteile in Kauf genommen werden müssen.

Durch die erfindungsgemäß vorgesehenen Begrenzungselemente ist beim Umpressen eines Chips, der auf dem Leadframe montiert ist, die Ausbreitung der von der dritten Seite in die Kavität des Umpreßwerkzeugs zuführbaren Preßmasse in der Weise beeinflußt, daß ein gleichmäßiger Preßmassenfluß oberhalb und unterhalb des Chips erreichbar ist.

Die Form und Anzahl der Begrenzungselemente kann jeweils so gestaltet sein, daß für beliebige Chipgrößen eine einheitliche Gehäusegröße herstellbar ist, ohne daß im Umpreßwerkzeug eine verlorene Kavität oder ein Anpassen der Lage von Chip und Leadframe in der ("normalen") Kavität notwendig ist. Stattdessen sind für unterschiedliche Chipgrößen lediglich erfindungsgemäße Leadframes mit verschieden gestalteten Begrenzungselementen notwendig. Es kann für die Gehäuseherstellung aber dasselbe Umpreßwerkzeug bei beiden Chipgrößen verwendet werden.

Die Erfindung wird im folgenden anhand der Figuren näher erläutert:
Figur 1 zeigt ein Ausführungsbeispiel des erfindungsgemäßen Leadframes.
Figur 2 zeigt ein Detail des Leadframes aus Figur 1, der auf einem Chip befestigt und in einem Umpreßwerkzeug angeordnet ist.

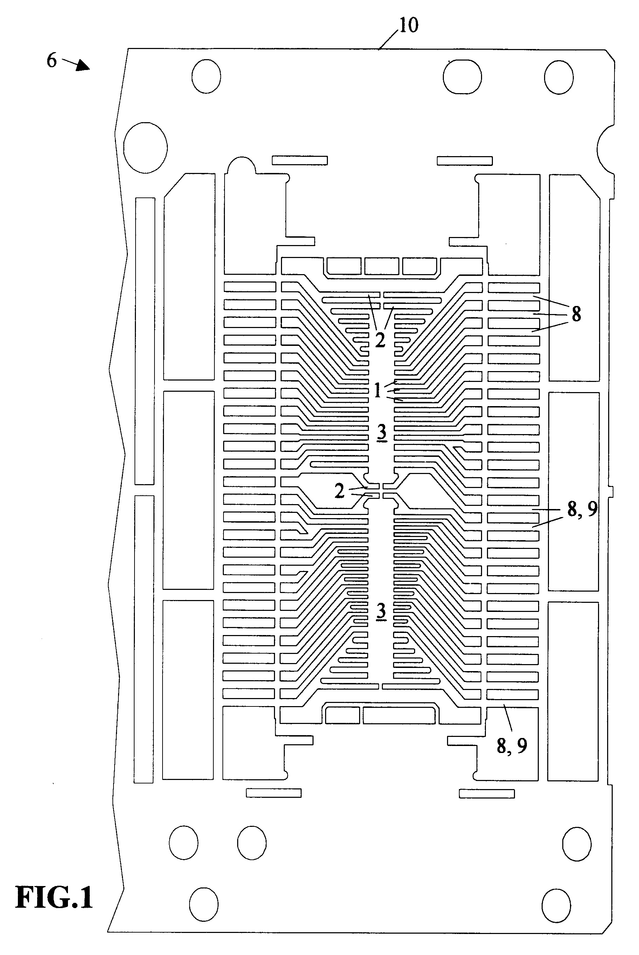

Der Leadframe 6 in Figur 1 weist erste innere Leads 1 und Begrenzungselemente 2 auf. Die Begrenzungselemente 2 sind bei diesem Ausführungsbeispiel der Erfindung zweite innere Leads und sind daher, wie die ersten inneren Leads 1, für die Kontaktierung mit Anschlußpads eines Chips vorgesehen. Daher sind sowohl den ersten inneren Leads 1 erste äußere Leads 8 als auch den Begrenzungselementen 2 Zweite äußere Leads 9 zugeordnet. Beim gezeigten Ausführungsbeispiel stimmen jedoch die zweiten äußeren Leads 9 mit einigen der ersten äußeren Leads 8 überein.

Die Leads 1, 2, 8, 9 sind mechanisch mit einem Rahmen 10 verbunden, der zur Handhabung des Leadframes 6 dient. Die Gestalt des Rahmens 10 ist für die Erfindung unerheblich und in Figur 1 nur beispielhaft angegeben. Er wird im Verlauf des Herstellungsprozesses eines Gehäuses für einen Chip entfernt, so daß anschließend nur noch die einander zugeordneten der inneren 1, 2 und äußeren 8, 9 Leads elektrisch miteinander verbunden sind.

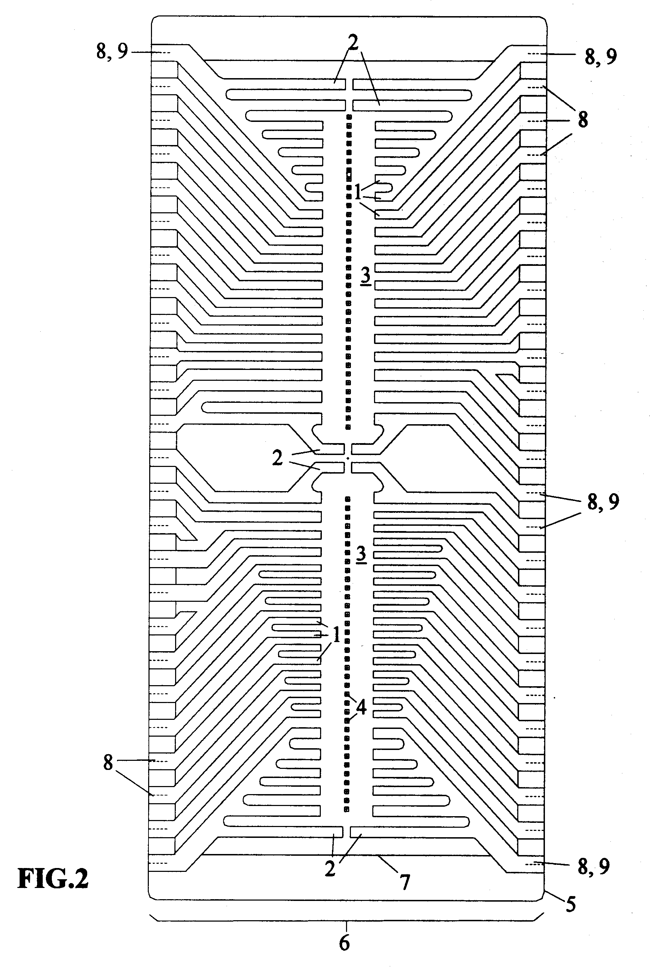

Die ersten inneren Leads 1 begrenzen in der Mitte des Leadframes 6 einen von Leads freien Bereich 3 nach links und rechts, also nach zwei sich gegenüberliegenden Seiten. Die Begrenzungselemente 2 begrenzen den freien Bereich 3 mehrfach nach oben, also nach einer dritten Seite. Die Funktion der Begrenzungselemente 2 wird im folgenden anhand der Figur 2 näher geschildert.

Bezüglich der Figur 2 wird nun das erfindungsgemäße Verfahren erläutert und der Leadframe aus Figur 1 sowie andere Ausführungsformen der Erfindung werden genauer erklärt. Figur 2 zeigt einen Schnitt durch eine Kavität 5 eines Umpreßwerkzeuges zur Herstellung eines Gehäuses, in der sich der in Figur 1 dargestellte Leadframe 6 nach erfolgter Montage auf einem Chip 7 befindet. Dargestellt sind nur die für das Verständnis notwendigen Einzelheiten des Leadframes 6 und des Chips 7.

Die ersten inneren Leads 1 und die Begrenzungselemente 2 (bei diesem Ausführungsbeispiel sind alle Begrenzungselemente 2, wie bereits erwähnt, zweite innere Leads) des Leadframes 6 sind mit der Oberseite des Chips 7 (beispielsweise über eine Klebefolie) mechanisch verbunden. Dabei ragen die ersten inneren Leads 1 von den zwei sich gegenüberliegenden Seiten (nämlich von links und rechts) auf den Chip 7 und begrenzen den von Leads freien Bereich 3 von diesen beiden Seiten. Im freien Bereich 3 sind Anschlußpads 4 des Chips 7 angeordnet. Bei diesem Ausführungsbeispiel sind die Pads 4 mittig entlang einer Achse des Chips 7 angeordnet. Sie sind mittels nicht dargestellter Bonddrähte mit den ersten 1 und zweiten inneren Leads verbindbar.

Die Begrenzungselemente 2 in Form der zweiten inneren Leads begrenzen den freien Bereich 3 mehrfach nach der dritten Seite, und zwar bei diesem Ausführungsbeispiel nach oben, von wo angenommenermaßen während der Herstellung des Chipgehäuses Preßmasse in die Kavität 5 eingepreßt wird. Durch diese mehrfache Begrenzung ist bei diesem Ausführungsbeispiel der freie Bereich 3 in zwei Teilbereiche unterteilt. Die Begrenzungselemente 2 sind so gestaltet, daß der in der Figur 2 von oben nach unten erfolgende Preßmassenfluß durch sie gebremst wird. Hierzu ragen sie von links und rechts weiter auf die Mitte des Chips, als die ersten inneren Leads 1.

Die ersten inneren Leads 1 sind den ersten äußeren Leads 8 und die Begrenzungselemente 2 den zweiten äußeren Leads 9 zugeordnet. Beim dargestellten Ausführungsbeispiel stimmen die zweiten äußeren Leads 9 mit einigen der ersten äußeren Leads 8 überein, d.h. einige der ersten inneren Leads 1 sind mit den Begrenzungselementen 2 auch nach Abschluß der Chipmontage, also nach Entfernen des Rahmens 10 (siehe Figur 1), elektrisch verbunden. Es kann sich bei diesen günstiger Weise um Versorgungspotentialanschlüsse des Chips 7 handeln, da für solche zur Reduzierung des elektrischen Widerstandes eine Zuführung mit großem Leitungsquerschnitt vorteilhaft ist.

Bei anderen Ausführungsformen der Erfindung können die ersten inneren Leads 1 nach Entfernen des Rahmens 10 (siehe Figur 1) auch von den zweiten inneren Leads elektrisch getrennt sein, so daß die zweiten äußeren Leads 9 mit keinem der ersten äußeren Leads 8 identisch sind, also die zweiten inneren Leads und die ersten inneren Leads 1 separate äußere Leads 8, 9 aufweisen.

Zur Herstellung des Gehäuses für den Chip 7 wird Preßmasse an einer seiner schmalen Seiten in die Kavität 5 des Umpreßwerkzeugs eingepreßt. Angenommenermaßen soll das Einpressen an der oberen Kante des herzustellenden Gehäuses (also an der dritten Seite) erfolgen. Ohne die Begrenzungselemente 2 käme es, insbesondere bei großflächigen Chips 7, zu einer höheren Ausbreitungsgeschwindigkeit der Preßmasse an der in der Figur 2 dargestellten Chipoberseite im Vergleich zur Chipunterseite. Außerdem würde sich die Preßmasse an der Chipoberseite in der Mitte sehr viel schneller als am Rand ausbreiten. Ursache hierfür ist vor allem der freie Bereich 3, in welchem sich die Preßmasse ohne Vorhandensein der Begrenzungselemente 2 sehr schnell ausbreiten kann.

Die erfindungsgemäßen Begrenzungselemente 2 dienen dazu, die Ausbreitung der Preßmasse an der Chipoberseite zu verlangsamen und zu vergleichmäßigen. Hierzu sind sie am oberen und unteren Rand sowie in der Mitte des Leadframes 6 in der Weise angeordnet, daß sie den freien Bereich 3 nach oben begrenzen bzw. unterteilen. Sie sind also quer zur Fließrichtung der Preßmasse angeordnet.

Es ist sinnvoll, wie in der Figur 2 abgebildet, in der Nähe des Preßmasseneingangs (des Gates) der Kavität 5 (also am oberen Rand des Chips 7 beim Ausführungsbeispiel in Figur 2) mehr Begrenzungselemente 2 vorzusehen, als weiter unten, da dann eine effektivere Bremsung des Preßmassenflusses bereits zu Beginn der Füllung der Kavität 5 erfolgt. In der Figur sind daher am oberen Rand und in der Mitte des Chips 7 je vier Begrenzungselemente 2 angeordnet, dagegen am unteren Rand nur zwei.

Statt der in den Figuren 1 und 2 paarweise gezeigten Begrenzungselemente 2, die jeweils in der Mitte aneinandergrenzen, kann auch vorgesehen sein, jeweils nur ein einzelnes Begrenzungselement 2 vorzusehen, welches nicht unterbrochen ist.

Alternativ zum geschilderten Ausführungsbeispiel ist es möglich, den gesamten Leadframe 6 oder zumindest die Begrenzungselemente 2 nicht achsensymmetrisch auszubilden. Dies wäre beispielsweise der Fall, wenn die Pads 4 nicht längs einer Achse des Chips 7 angeordnet wären.

Die Begrenzungselemente 2 können bei anderen Ausführungsformen der Erfindung anstelle von zweiten Leads auch sonstige Komponenten des Leadframes 6 sein, die keine elektrische Funktion übernehmen und daher mit keinem Anschlußpad 4 und keinem weiteren äußeren Lead 9 verbunden sind. Ihre alleinige Funktion ist es dann, die Ausbreitung der Preßmasse während der Gehäuseherstellung zu beeinflussen.

Es ist auch möglich, daß, anders als in den Figuren dargestellt, die ersten äußeren Leads 8 an mehr als den beiden sich gegenüberliegenden Seiten angeordnet sind. Wenigstens einer der zweiten äußeren Leads 9 kann auch an der dritten Seite oder an der ihr gegenüberliegenden Seite angeordnet sein.

Im Extremfall kann nur ein Begrenzungselement 2 vorgesehen sein. Natürlich ist dann die Beeinflussung der Ausbreitung der Preßmasse relativ gering.

Die Anzahl, Anordnung und Form der Begrenzungselemente 2 ist natürlich an das Design des Chips 7, wie Lage der Anschlußpads 4 usw., anzupassen, damit das Ziel eines vergleichmäßigten Preßmassenflusses in optimaler Weise erreicht wird.

## Patentansprüche

1. Leadframe für die Lead-on-Chip-Montage mit folgenden Merkmalen:
- Er weist eine Vielzahl von ersten inneren Leads (1) zur inneren Kontaktierung des Leadframes (6) mit Anschlußpads (4) eines Chips (7) auf, die jeweils einem ersten äußeren Lead (8) zur äußeren Kontaktierung des Leadframes (6) zugeordnet sind,
- die ersten inneren Leads (1) begrenzen mit ihren für die innere Kontaktierung vorgesehenen Enden einen innerhalb des Leadframes (6) angeordneten, von Leads freien Bereich (3) nach zwei sich gegenüberliegenden Seiten,
- der Leadframe (6) weist wenigstens ein Begrenzungselement (2) auf, das bzw. die den freien Bereich (3) nach einer dritten Seite begrenzen.

2. Leadframe nach Anspruch 1,
bei dem eines der Begrenzungselemente (2) ein zweiter innerer Lead ist, der einem zweiten äußeren Lead (9) zugeordnet ist.

3. Leadframe nach Anspruch 2,
bei dem der zweite äußere Lead (9) einer der ersten äußeren Leads (8) ist.

4. Leadframe nach einem der vorstehenden Ansprüche,
bei dem sich eines der Begrenzungselemente (2) von einer der beiden sich gegenüberliegenden Seiten in Richtung der anderen erstreckt.

5. Leadframe nach Anspruch 4,
bei dem eines der Begrenzungselemente (2) nach erfolgter Montage des Chips (7) auf dem Leadframe (6) am Rand des Chips (7) angeordnet ist.

6. Leadframe nach einem der vorstehenden Ansprüche, bei dem die Begrenzungselemente (2), betrachtet von der dritten Seite, über die Länge des Leadframes (6) verteilt angeordnet sind, so daß eine mehrfache Begrenzung des freien Bereiches (3) nach der dritten Seite vorliegt.

7. Leadframe nach einem der vorstehenden Ansprüche, bei dem die ersten äußeren Leads (8) an den zwei sich gegenüberliegenden Seiten des Leadframes (6) angeordnet sind.

8. Leadframe nach einem der Ansprüche 2 bis 7, bei dem der zweite äußere Lead (9) an einer der zwei sich gegenüberliegenden Seiten des Leadframes (6) angeordnet ist.

9. Verwendung eines Leadframes nach einem der vorstehenden Ansprüche zur Herstellung eines Gehäuses für einen in Lead-on-Chip-Technik auf dem Leadframe befestigten Chip mit folgenden Schritten:
- Der Chip (7) wird mit dem Leadframe (6) in eine Kavität (5) eines Umpreßwerkzeuges eingebracht,
- von der dritten Seite wird Preßmasse in die Kavität (5) eingepreßt.
